(19) Europäisches Patentamt
European Patent Office
Office européen des brevets

(11) Veröffentlichungsnummer: **0 177 453**
**B1**

(12) # EUROPÄISCHE PATENTSCHRIFT

(45) Veröffentlichungstag der Patentschrift: **16.12.87**

(51) Int. Cl.$^4$: **G 03 F 7/16,** G 03 C 1/68

(21) Anmeldenummer: **85810448.2**

(22) Anmeldetag: **30.09.85**

(54) **Verfahren zur Bilderzeugung.**

(30) Priorität: **04.10.84 GB 8425124**
**19.12.84 GB 8432106**

(43) Veröffentlichungstag der Anmeldung:
**09.04.86 Patentblatt 86/15**

(45) Bekanntmachung des Hinweises auf die Patenterteilung:
**16.12.87 Patentblatt 87/51**

(84) Benannte Vertragsstaaten:
**BE CH DE FR GB IT LI NL SE**

(56) Entgegenhaltungen:
**US-A-4 227 978**
**US-A-4 416 752**

(73) Patentinhaber: **CIBA- GEIGY AG, Klybeckstrasse 141, CH- 4002 Basel (CH)**

(72) Erfinder: **Banks, Christopher Paul, 105 Ross Close, Saffron Walden Essex CB11 4DU (GB)**
Erfinder: **Irving, Edward, Dr., 41, Swaffham Road, Burwell Cambridge CB5 0AN (GB)**

**EP 0 177 453 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1987

**Beschreibung**

Die vorliegende Erfindung betrifft ein Verfahren zur Bilderzeugung durch elektroinitiierte Polymerisation, gefolgt von aktinischer Bestrahlung.

Auf konventionelle Art wird die Bilderzeugung durch Photopolymerisation dadurch erreicht, dass eine Unterlage mit einer Lösung einer festen photopolymerisierbaren Verbindung in einem flüchtigen organischen Lösungsmittel beschichtet wird, das Lösungsmittel eingedampft wird, um eine feste Schicht der photopolymerisierbaren Verbindung zu erhalten, und diese Schicht durch ein Negativ bestrahlt wird, so dass es auf der bestrahlten Fläche zu einer Polymerisation kommt. Die nicht-photopolymerisierten Teile der Schicht werden dann mit einem geeigneten Lösungsmittel entfernt, wobei diese Phase "Entwicklung" genannt wird. Nach der Entwicklung kann die bestrahlte Fläche, von welcher nicht-photopolymerisiertes Material entfernt worden ist, geätzt werden, um eine Leiterplatte oder gedruckte Schaltung zu bilden.

Bilder wurden auch nach einem ähnlichen Verfahren, in dem das photopolymerisierbare Material durch einen positiven Photoresist ersetzt wurde, erzeugt. Dies ist ein Material, das durch aktinische Bestrahlung löslicher im Entwicklerlösungsmittel wird. Bestrahlung durch einen bildtragenden Film, gefolgt von Entwicklung, führt dadurch zur Erzeugung eines positiven Bildes.

Um eine möglichst genaue Bilderzeugung zu erreichen, ist es wünschenswert eine möglichst dünne Schicht des photoenpfindlichen Stoffes zu haben, d.h. des Stoffes welcher nach aktinischer Bestrahlung eine Änderung der Löslichkeit erfährt, indem er in Entwickler mehr oder weniger löslich wird.

Das Bedürfnis nach dünnen Schichten photoempfindlicher Stoffe folgt aus der Notwendigkeit, die Lichtstreuung in abgeschiedenen Film zu minimisieren. Diese Streuung ist proportional zur Dicke des Films, so dass bei zu dickem Film sehr feine Linien nicht reproduziert werden können. Zudem muss der Überzug frei von kleinen Poren und Mängeln sein, da diese die Leiterplatte oder die gedruckte Schaltung, welche so hergestellt wurden, beeinträchtigen würden. Die Applikation von sehr dünnen einwandfreien Überzügen wirft ernsthafte Probleme auf, welche noch grösser werden, wenn die zu beschichtende Oberfläche sogar die kleinsten Unregelmässigkeiten aufweist, oder wo die zu beschichtende Platte auf beiden Seiten beschichtet werden soll und/oder Löcher aufweist, die auch beschichtet werden müssen.

Ein weiteres Erfordernis einer photoempfindlichen Schicht ist, dass sie vor der Bestrahlung fest werden sollte. Wie oben erwähnt, wird das durch die Applikation eines an sich festen Harzes in Lösung in einem flüchtigen Lösungsmittel, welches dann eingedampft wird, erreicht. Die Applikation von Filmen auf diese Art kann aufgrund der Bildung einer festen "Haut" des photoempfindlichen Materials, durch welche das restliche Lösungsmittel durchkommen muss, zu kleineren Unvollkommenheiten führen und kleine Poren verursachen. Andererseits, falls ein an sich flüssiges oder halb-flüssiges photoempfindliches Material, d.h. eine lösungsmittelfreie Flüssigkeit, verwendet wird, kann es aufgrund des Fliessens des Stoffgemisches nach der Bilderzeugung zu Mängeln kommen. Solche Stoffgemische sind zusätzlich nicht einfach anzuwenden, da Filme oder andere bilderzeugende Materialien, wegen dessen Klebrigkeit nicht direkt in Kontakt mit dem Stoffgemisch gebracht werden können.

Folglich besteht ein Bedürfnis nach einem Verfahren zur Bildung eines an sich festen photoempfindlichen Harzes in Form einer sehr dünnen, einwandfreien Schicht auf einem Substrat, welches unabhängig von der Form des Substrats anwendbar ist. Im vorliegenden Verfahren wird eine feste polymerisierte, aber immer noch photoempfindliche Schicht auf einer Elektrode gebildet, welche in eine Lösung oder Dispersion eines flüssigen photoempfindlichen Stoffgemisches eingetaucht ist, das zusätzlich ein Reagens enthält, welches eine schnelle Polymerisation des Stoffgemisches unter den Reaktionsbedingungen einleitet, es aber noch photoempfindlich belässt. Die elektroinitiierte Polymerisation findet auf der Elektrode statt, welche dann als Substrat für das photoempfindliche Material während der aktinischen Bestrahlung dient. Die Dicke der abgeschiedenen polymerisierten Schicht kann durch Modifizierung der Abscheidungsbedingungen einfach kontrolliert werden, und die Herstellung sehr dünner Überzüge ist möglich. Da es sich um ein elektrolytisches Verfahren handelt, werden alle leitenden Oberflächen des Substrats beschichtet, unabhängig davon, ob sie glatt oder uneben sind, oder ob sie Löcher aufweisen. Es wurde auch gefunden, dass der Lösungsmitteleinschluss minimal ist, so dass die bei konventionellen Verfahren üblichen, durch Lösungsmittelverdampfung entstandenen kleinen Poren nicht gebildet werden.

Die Applikation einer photoempfindlichen Schicht durch galvanische Abscheidung ist bekannt. Die britische Patentschrift 1 489 402 z. B. beschreibt photohärtbare Harzgemische, welche bestimmte Vinyl- und Vinylidenharze mit an die Hauptkette gebundenen freien Säuregruppen enthalten, und sagt, dass diese Stoffgemische durch galvanische Abscheidung auf metallische Substrate appliziert werden können. In der US Patentschrift 3 738 835 werden Photoresistgemische beschrieben, welche aus Emulsionen enthaltend eine photoempfindliche Komponente, ein Polychloropren und einen Sensibilisator und, um die Klebrigkeit des Photopolymers zu vermeiden, ein polymeres Harzbindemittel, wie z. B. ein teilweise mit Dicyandiamid ausgehärtetes Epoxidharz, durch Elektrophorese auf ein Metallsubstrat, abgeschieden werden. Diese Emulsionen enthalten zusätzlich noch Stabilisatoren, Netzmittel, oberflächenaktive Verbindungen, N-Methyl-2-pyrrolidon und Triethanolamin. Das Photoresistgemisch wird einfach aus der Emulsion auf das Substrat abgeschieden, ohne dass während der Abscheidung eine Polymerisation oder eine Härtungsreaktion stattfindet. Um bei der Verwendung des Epoxidharzes ein festes Harzbindemittel zu erhalten, muss in einer Vorstufe vor dem Einführen des Harzes in die Emulsion eine teilweise Polymerisation durchgeführt werden. Da diese Stufe ein nicht nur festes, sondern auch unlösliches Produkt liefert, werden die Stoffgemische

gezwungenermassen aus einer Emulsion der Komponenten abgeschieden. Eine Abscheidung aus Lösungen ist nicht möglich.

Die US Patentschrift 4 416 752 beschreibt ein Verfahren zur Elektroinitiierung der kationischen Polymerisation auf der Oberfläche eines Metallsubstrats. Das Substrat wird als Anode in einem elektrolysierten Gemisch eines kationisch polymerisierbaren organischen Stoffes, wie z. B. eines Epoxidharzes und eines Aryliodonium- oder Arylsulfoniumsalzes, wie z. B. Hexaflurphosphat, eingesetzt.

In keiner dieser Patentschriften wird ein Verfahren beschrieben, in dem auf der Oberfläche eines Substrats, welches als Elektrode dient, durch Polymerisation ein fester Photoresist entsteht. Ein Vorteil des vorliegenden Verfahrens liegt in der Tatsache, dass handelsübliche flüssige Harze als Stoffe, welche unter den elektroinitiierten Polymerisationsbedingungen polymerisieren, verwendet werden können. Um es galvanisch abscheidbar zu machen, ist keine spezielle Modifikation des Harzes nötig, weil das Polymerisationsreagens zur Elektrode migriert und dort aktiviert wird. Das handelsübliche Harz wird wegen der Freisetzung einer polymerisierenden Spezies beim Kontakt mit der Elektrode fest, so dass das Harz selber elektrisch gänzlich inert sein kann.

Die vorliegende Erfindung betrifft ein Verfahren zur Bilderzeugung auf Substraten, worin man

(i) das Substrat als Elektrode in ein flüssiges Stoffgemisch eintaucht, welches

(A) ein kationisch polymerisierbares Material,

(B) ein durch elektrischen Strom aktivierbares Polymerisierungsreagens für (A) und

(C) ein photoempfindliches Material enthält,

(ii) durch das flüssige Stoffgemisch zwischen dem Substrat und einer anderen Elektrode elektrischen Strom durchleitet, so dass an der Oberfläche des Substrats eine photoempfindliche Schicht des im wesentlichen festen polymerisierten Materials abgeschieden wird,

(iii) das Substrat aus dem flüssigen Stoffgemisch entfernt,

(iv) die photoempfindliche Schicht in einem vorbestimmten Muster mit aktinischer Strahlung belichtet, um einen Unterschied in der Löslichkeit zwischen den belichteten und den unbelichteten Teilen der Schicht zu erreichen, und

(v) die löslicheren Teile der Schicht durch Behandlung mit einem Lösungsmittel entfernt, und die weniger löslichen Teile der Schicht auf dem Substrat belässt.

Der Satz "in einem vorbestimmten Muster..... belichtet" umfasst sowohl die Bestrahlung durch einen bildtragenden Film, als auch Bestrahlung mit einem Energiestrahl wie z. B. einem vom Computer dirigierten Laserstrahl, um ein Bild zu erzeugen.

Das flüssige Stoffgemisch nach der vorliegenden Erfindung kann ein Gemisch einer oder mehrerer Verbindungen (A) darstellen, welche ausschliesslich kationisch polymerisierbar sind, mit einer oder mehreren Verbindungen (C), welche ausschliesslich photoempfindlich sind. Es kann andererseits auch eine oder mehrere doppelfunktionelle Verbindungen enthalten, d.h. Verbindungen, welche sowohl kationisch polymerisierbar als auch photoempfindlich sind. Solche doppelte Aktivität kann entweder auf verschiedene Gruppen im gleichen Molekül zurückgeführt werden, oder auf gleiche Gruppen, welche sowohl der elektroinitiierten kationischen als auch der Photopolymerisation fähig sind. In dieser Ausführungsform sind (A) und (C) die gleiche Verbindung. Weiterhin kann das Stoffgemisch auch ein Gemisch einer oder mehrerer doppelfunktioneller Verbindungen mit einer oder mehreren ausschliesslich kationisch polymerisierbaren Verbindungen und/oder einer oder mehreren ausschliesslich photoempfindlichen Verbindungen enthalten.

Der kationisch polymerisierbare Stoff (A) kann beispielsweise ein cyclischer Ether, wie z. B. ein Oxetan oder ein Tetrahydrofuran, ein cyclischer Ester, wie z. B. ein Lacton, ein Episulfid, wie z. B. Ethylensulfid oder ein Episulfidharz, ein Vinylmonomer, wie z. B. ein Vinylether, ein Styrol oder ein Vinylcarbazol, oder ein Vinylpräpolymer sein. Vorzugsweise ist (A) ein 1,2-Epoxid, wie z. B. Ethylenoxid, Propylenoxid, ein Monoglycidylether oder ein Epoxidharz, ein Phenoplast, ein Aminoplast, wie z. B. ein Harnstoff-Formaldehyd- oder ein Melamin-Formaldehydharz, oder ein cyclischer Vinylether. Besonders bevorzugte kationisch polymerisierbare Stoffe sind cycloaliphatische Epoxidharze, wie z. B. 3,4-Epoxycyclohexylmethyl- 3',4'-epoxycyclohexancarboxylat und dessen 6,6'-Dimethylderivat, Ethylen-glykol-bis(3,4-epoxycyclohexancarboxylat), Bis(3,4-epoxycyclohexylmethyl)adipat Dicyclopentadiendioxid und Vinylcyclohexendioxid, Monoglycidylether, wie z. B. Isooctylglycidylether und Phenylglycidylether, gegebenenfalls vorverlängerte Polyglycidylether von mehrwertigen Alkoholen, wie z. B. 1,4-Butandiol und Diethylenglykol und von mehrwertigen Phenolen, wie z. B. 2,2-Bis(4-hydroxyphenyl)propan und Phenol-Aldehyd-Novolake, cyclische Venylether, welche ein Dihydropyranrest enthalten, wie z. B. 3,4-Dihydro-2H-pyran-2-ylmethyl-3',4'-dihydro-2H-pyran-2-carboxylat, und Phenol-Formaldehyd-Resole. Gemische von zwei oder mehreren kationisch polymerisierbaren Stoffen können auch verwendet werden.

Geeignete Polymerisierungsreagentien (B) für den polymerisierbaren Stoff (A) umfassen Salze und Komplexe von Lewis Säuren mit organischen Stoffen, welche während der Elektrolyse eine polymerisierende Spezies freisetzen. Salze umfassen Verbindungen der Formel

$$[A^{y+}]_a \quad [Z^{x-}]_b \qquad I,$$

worin

$A^{y+}$ ein Kation, welches vorzugsweise ein Metall, ein Metallkomplex, eine organometallische oder eine heterocyclische Verbindung oder ein Ammonium-, ein Sulfonium-, ein Iodonium-, ein Sulfoxonium-, ein Iodosyl-, ein substituiertes Ammonium- oder ein Phosphoniumion ist,

$Z^{x-}$ ein Anion einer protischen Säure ist, und

a, b, x und y jeweils 1, 2 oder 3 bedeuten, wobei (ay) gleich (bx) ist.

Geeignete Kationen $A^{y+}$ sind solche von Metallen, insbesondere von Alkali- oder Erdalkalimetallen, wie z. B. Natrium, Kalium, Magnesium oder Calcium, Ammonium, substituierte Phosphonium der Formel

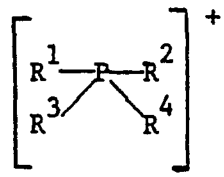

II,

und substituierte Ammonium der Formel

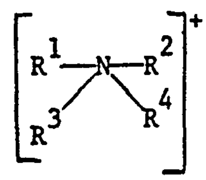

III,

worin $R^1$, $R^2$, $R^3$ und $R^4$, gleich oder verschieden sind und gegebenenfalls substituierte Alkyl-, Alkenyl-, Aryl-, Aralkyl-, Cycloalkyl- oder Cycloalkylalkylgruppen bedeuten oder $R^1$ und $R^2$, und/oder $R^3$ und $R^4$, zusammen mit dem Stickstoff- oder Phosphoratom an das sie gebunden sind, einen heterocyclischen Ring, welcher einen oder mehrere zusätzliche Heteroatome enthalten kann, bilden.

Weitere geeignete Kationen $A^{y+}$ umfassen Sulfoniumkationen, wie z. B. Triaryl- und Arylalkylsulfoniumkationen, beispielsweise Triphenylsulfonium- und Phenyldimethylsulfoniumion, Iodoniumkationen, insbesondere Diaryliodoniumkationen wie z. B. Diphenyliodonium, Bis(3,4-dimethylphenyl)iodonium und Di-(o-tolyl)iodonium, Sulfoxoniumkationen wie z. B. Triaryl-, Trialkyl-, Arylalkyl-, Aracylalkyl- und Acylalkylsulfoxoniumkationen, beispielsweise Triphenylsulfoxonium, Trimethylsulfoxonium, Phenyldimethyl-, Phenacyldimethyl- und Acetylmethyldimethylsulfoxonium, Iodosylkationen, insbesondere Diaryliodosylkationen, wie z. B. Diphenyliodosyl, heterocyclische Kationen, wie z. B. 2,4,6-Alkyl- oder Arylpyryliumkationen, komplexierte Metallkationen, wie z. B. Übergangsmetall-Ammonium oder -Amikomplexkationen, und organometallische Kationen, wie z. B. $\eta^5$ -Cyclopentadienyltricarbonyl, $\eta^6$-Arentricarbonyl, $\eta^7$-Cycloheptatrienyltricarbonyl, Bis($\eta^5$-cyclopentadienyl), Bis($\eta^6$ -aren) und ($\eta^6$-Aren) ($\eta^5$ -Cyclopentadienyl) Übergangsmetallkationen.

Geeignete Anione $Z^{x-}$ sind solche, die von organischen Carbonsäuren abgeleitet werden, wie z. B. Acetate und Trifluoracetate, solche, die von Sulfonsäuren $Y\text{-}SO_3H$ abgeleitet werden, worin Y eine aliphatische, aromatische oder aliphatisch-substituierte aromatische Gruppe bedeutet, insbesondere mit 1 bis 20, 5 bis 20 bzw. 6 bis 20 Kohlenstoffatomen, vorzugsweise eine gegebenenfalls mit einem oder mehreren Halogenatomen substituierte Alkyl-, Aryl- oder Aralkylgruppe, wie z. B. Methansulfonate, Benzolsulfonate, Toluol-p-sulfonate und Trifluormethansulfonate, sowie solche, die von anorganischen Säuren abgeleitet werden, wie beispielsweise Halogenide, wie z. B. Fluoride, Chloride und Bromide, Halate, wie z. B. Iodate, Perhalate, wie z. B. Perchlorate, sowie Nitrate, Sulfate, Hydrogensulfate, Phosphate, Hydrogenphosphate und komplexe Anione, wie z. B. Pentafluorhydroxoantimonate und solche der Formel $MQ_d^-$, worin M für ein Metalloder Metalloidatom, ausgewählt aus Bor, Phosphor, Antimon und Arsen steht, Q ein Halogenatom darstellt, und d eine ganze Zahl von 4 bis 6, die um eins höher als die Wertigkeit von M ist, bedeutet.

Bevorzugte Salze gemäss dem erfindungsgemässen Verfahren sind Natrium-, Kalium-, Ammonium-, substituierte Phosphonium- und substituierte Ammoniumsalze der Formeln II und III, in welchen $R^1$, $R^2$, $R^3$ und $R^4$ gleiche oder verschiedene unsubstituierte Alkylgruppen mit bis zu 6 Kohlenstoffatomen, Aralkylgruppen mit 7 bis 10 Kohlenstoffatomen oder Arylgruppen mit 6 bis 10 Kohlenstoffatomen, Trimethylsulfoxonium-, Triphenylsulfonium-, Diphenyliodonium-, Diphenyliodosyl- und ($\eta^6$-Isopropylbenzol)-($\eta^6$ -Cyclopentadienyl)eisen(II)salze mit Chlorid-, Perchlorat-, Acetat-, Tetrafluorborat-, Hexafluorphosphat-, Hexafluorarsenat- oder Hexafluorantimonatanionen. Besonders bevorzugte Salze sind Kaliumhexafluorphosphat, Tetramethylammoniumhexafluorantimonat, Trimethylsulfoxonium- und Triphenylsulfoniumhexafluorantimonat und ($\eta^6$-Isopropylbenzol) ($\eta^6$-

cyclopentadienyl)eisen(II)hexafluorantimonat.

Lewissäurekomplexe, die als Polymerisierungsreagens verwendet werden können, umfassen Komplexe von Bortrifluorid, Bortrichlorid, Aluminiumtrichlorid, Antimontrichlorid und Zinntetrachlorid mit einem Alkohol, Ether, einer Säure, einem Amin, Amid, Ester oder trisubstituierten Phosphin. Bevorzugt sind Komplexe von Bortrifluorid mit Aminen, welche N-Heterocyclen, Amin-substituierte Heterocyclen, aliphatische, cycloaliphatische oder araliphatische Amine sein können, und mit Phosphinen, die durch drei aliphatische oder aromatische Gruppen substituiert sind. Besonders bevorzugt sind Komplexe von Bortrifluorid mit Pyridin, Piperidin, Mono-, Di-, und Triethylamin, Mono-, Di-, und Trimethylamin, Isophorondiamin, Benzylamin, Cyclohexylamin, N,N,N',N',-Tetramethylhexamethylendiamin, Trimethylphosphin und Triphenylphosphin.

Das polymerisierbare Material (A) und Reagens (B) werden so gewählt, dass eine wirksame Polymerisation stattfindet. Das Anpassen von geeigneten kationisch polymerisierbaren Stoffen mit geeigneten Polymerisierungsreagenzien ist dem Fachmann auf dem Gebiet der Polymerisierung von kationisch polymerisierbaren Stoffgemischen wohl bekannt. So können z. B. Salze, welche von organischen Carbonsäuren, organischen Sulfonsäuren und anorganischen Säuren abgeleitete Anione aufweisen, insbesondere Acetate, Trifluoracetate, Methansulfonate, Benzolsulfonate, Toluol-p-sulfonate, Trifluormethansulfonate, Fluoride, Chloride, Bromide, Iodate, Perchlorate, Nitrate, Sulfate, Hydrogensulfate, Phosphate oder Hyerogenphosphate, die Härtung von Phenoplasten, wie z. B. Phenol- Formaldehydharzen, und Aminoplasten, wie z. B. Harnstoff-Formaldehyd- und Melamin-Formaldehydharzen einleiten. Salze mit einem Metallhalogenid- oder Metalloidhalogenidanion und die Lewissäurekomplexe können die Härtung von Epoxidharzen oder Episulfidharzen, oder die Polymerisierung von Mono-1,2-epoxiden, Monoepisulfiden oder von Vinylethern einleiten.

Das photoempfindliche Material (C) kann photohärtbar sein, was ein Negativbild ergibt, oder photosolubilisierbar sein, was ein Positivbild ergibt. Geeignete photohärtbare Stoffe umfassen solche, in welchen die Härtung durch direkte Strahlungsaktivierung der photoempfindlichen Gruppen stattfindet, sowie solche in denen die Strahlung ein geeignetes Initiatormolekül aktiviert, welches seinerseits dann die photoempfindlichen Gruppen aktiviert.

Photohärtbare Stoffe mit photoempfindlichen Gruppen sind wohl bekannt und umfassen solche mit einer oder mehreren, insbesondere mindestens zwei Gruppen, welche Azido-, Coumarin-, Stilben-, Maleimido-, Pyridinon-, Chalcon- (umfassend Propenon und Pentadienon) oder Anthracengruppen, oder Acrylsäureestergruppen, welche in der 3-Stellung eine Gruppe mit ethylenischer Doppelbindung oder Aromaten in Konjugation mit der ethylenischen Doppelbindung der Acrylgruppe aufweisen, sind.

Stoffe, bei denen die Strahlungshärtung durch Aktivierung eines Photoinitiators, welcher dann die härtbaren Gruppen aktiviert, stattfindet, umfassen Epoxidharze, Phenolharze, Harnstoff-Formaldehydharze, cyclische Ether, cyclische Ester, cyclische Sulfide, cyclische Amine und organosilicium-cyclische Verbindungen in Kombination mit einem strahlungsempfindlichen aromatischen Oniumsalz, wie z. B. Diazonium, Sulfonium, Iodonium und Sulfoxoniumsalz, oder einem strahlungsempfindlichen aromatischen Iodosylsalz, sowie Teilester oder Ester der Acryl- und Methacrylsäure mit aliphatischen Alkoholen, Glykolen oder Polyolen, oder mit einer Verbindung, welche eine oder mehrere Epoxidgruppen enthält, sowie Ester erhalten durch die Umsetzung eines Epoxids mit einem Addukt eines Hydroxyalkylacrylats oder -methacrylats mit einem gesättigten oder ungesättigten Polycarbonsäureanhydrid.

Es ist klar, dass manche der photohärtbaren Stoffe, die als (C) verwendet werden können, identisch mit den Gemischen des kationisch polymerisierbaren Stoffes (A) und des Polymerisierungsreagens (B) sind. Es wurde gefunden, dass in den Fällen in welchen das Polymerisierungsreagens (B) sowohl durch den elektrischen Strom als auch durch aktinische Strahlung aktiviert werden kann, und die anfängliche Härtung, wie beschrieben, auf der Oberfläche des Substrats stattfindet, auf dem Substrat immer noch eine genügende Menge des nichtreagierten Polymerisierungsreagens verbleibt, um bei Bestrahlung als Photohärtungsreagens zu wirken.

Photosolubilisierbare Stoffe, die als Komponente (C) verwendet werden können, umfassen o-Nitrobenzaldehyd, die in der US Patentschrift 3 991 033 beschriebenen Polyoxymethylenpolymere, die in der US Patentschrift 3 849 137 beschriebenen o-Nitrocarbinolester, die in der US Patentschrift 4 086 210 beschriebenen o-Nitrophenylacetale, deren Polyester und verkappte Derivate, sowie Sulfonatester von aromatischen Alkoholen, die eine Carbonylgruppe in der alpha- oder beta-Stellung zur Sulfonatestergruppe aufweisen, N-Sulfonyloxyderivate eines aromatischen Amids oder Imids, Chinondiazide, wie z. B. die in den britischen Patentschriften 1 227 602 und 1 329 888 beschriebenen, sowie Benzoingruppen in der Kette enthaltende Harze, wie z. B. die in der US Patentschrift 4 368 253 beschrieben.

Bevorzugte photohärtbare Stoffe, die als Komponente (C) verwendet werden, sind Epoxidharze, insbesondere cycloaliphatische Epoxidharze und Polyglycidylether von mehrwertigen Alkoholen und Phenolen, zusammen mit einem strahlungsempfindlichen aromatischen Onium- oder Iodosylsalz, Ester von Acryl- oder Methacrylsäure, insbesondere Ester mit cycloaliphatischen Epoxidharzen und Polyglycidylether von mehrwertigen Alkoholen und Phenolen, sowie Chalcone.

Photohärtbare Stoffe, welche verschiedene während der elektroinitiierten Polymerisation polymerisierbare Gruppen enthalten, d.h. doppelfunktionelle Stoffe, die sowohl als Komponente (A) als auch als Komponente (C) wirken können, umfassen epoxidgruppenhaltige Acrylate, Mathacrylate, Chalcone und Cinnamate, methylolgruppenhaltige Acrylate, Mathacrylate, Chalcone und Cinnamate und vinylgruppenhaltige Chalcone.

Solche doppelfunktionellen Stoffe können durch Umsetzung einer Substanz mit einer kationisch

polymerisierbaren Gruppe mit einer Substanz mit einer photohärtbaren Gruppe hergestellt werden, wobei die zwei Substanzen miteinander umsetzbare Gruppen aufweisen mussen. Wenn eine Verbindung zwei oder mehrere ähnliche reaktive Gruppen, welche kationisch polymerisierbar oder photohärtbar sind, aufweist, wie das bei einem Epoxidharz der Fall ist, und die Herstellung des doppelfunktionellen Stoffes die Verwendung dieser Verbindung im stöchiometrischen Überschuss mit sich bringt, so dass nur ein Teil dieser Gruppen umgesetzt wird, ergibt dieses Verfahren üblicherweise nicht eine 100 %-ige Ausbeute der Verbindung, die beide Arten von Gruppen enthält. In der Praxis wird ein Gemisch der nichtumgesetzten, im Überschuss eingesetzten Verbindung, des gänzlich umgesetzten Stoffes und des doppelfunktionellen Stoffes erhalten, d.h. ein Gemisch des ausschliesslich kationisch polymerisierbaren, des ausschliesslich photohärtbaren und des doppelfunktionellen Stoffes wird gebildet. Da solche Gemische im erfindungsgemässen Verfahren mit Erfolg eingesetzt werden können, spielt die Tatsache, dass das Reaktionsprodukt ein Gemisch ist, keine Rolle.

So kann der geeignete doppelfunktionelle Stoff durch Umsetzung eines Epoxidharzes mit weniger als der stöchiometrischen Menge einer Carbonsäure oder eines Phenols, welche eine photohärtbare Gruppe enthalten, erhalten werden. Andere geeignete doppelfunktionelle Stoffe können durch konventionelle Glycidylierung einer eine photohärtbare Gruppe enthaltenden Verbindung, wie z. B. eines Acrylats, Methacrylats oder Chalcons, erhalten werden, indem so die Epoxidgruppe eingeführt wird.

Besonders bevorzugte photohärtbare Stoffe sind Epoxidharze, insbesondere solche, die bereits als bevorzugte kationisch polymerisierbare Stoffe beschrieben wurden, im Gemisch mit einem Triarylsulfonium-, Diaryliodonium- oder Diaryliodosylhexafluorphosphat, -tetrafluorborat oder -hexafluorantimanat, Ester oder Teilester der Acryl- und Methacrylsäure mit Glykolen, wie z. B. Ethylenglykol, Triethylenglykol und Tetraethylenglykol, Ester erhalten durch Umglycidylether eines Mono- oder Polyalkohols oder -phenols, ein cycloaliphatisches Epoxidharz oder ein N-Glycidylhydantoin, und Ester erhalten durch Umsetzung solcher Epoxide mit einem Addukt insbesondere Bernsteinsäure-, Maleinsäure- oder Phthalsäureanhydrid, und Chalcone, die eine Gruppe der Formel

$-Ar-R^5-Ar-R^6$ IV

enthalten, worin Ar eine gegebenenfalls substituierte Phenylengruppe, $R^5$ eine Gruppe der Formel

$-[-CH=C(R^7)-]_m-CO-[-C(R^7)=CH-]_n-$ V

oder

$-CO-C(R^8)=CH-Ar-Ar-CH=C(R^8)-CO-$ VI

$R^6$ eine einfache Bindung oder ein Wasserstoffatom,

$R^7$ ein Wasserstoffatom, eine Alkylgruppe mit 1 bis 4 Kohlenstoffatomen oder eine Phenylgruppe, oder beide $R^7$ Gruppen zusammen eine Polymethylenkette mit 2 bis 4 Methylengruppen,

$R^8$ ein Wasserstoffatom, eine Alkylgruppe mit 1 bis 4 Kohlenstoffatomen, oder eine Phenylgruppe und m und n jeweils 0,1 oder 2 bedeuten, mit der Massgabe, dass nicht beide Null sind.

Bevorzugte doppelfunktionelle Stoffe mit einer kationisch polymerisierbaren Gruppe und einer verschiedenen photohärtbaren Gruppe im gleichen Molekül sind Umsetzungsprodukte von Epoxidharzen, insbesondere von cycloaliphatischen Epoxidharzen und Polyglycidylethern von mehrwertigen Phenolen, wie z. B. 2,2-Bis(4-hydroxyphenyl)propan, Bis(4-hydroxyphenyl)methan und Novolakharzen, mit weniger als der stöchiometrischen Menge einer Acryl-, Methacryl- oder Zimtsäure, oder eines chalcongruppenhaltigen Phenols, insbesondere eines Phenols mit Chalcongruppen der Formel IV. Weitere solche bevorzugte doppelfunktionelle Stoffe sind Glycidylether von Phenolen, welche eine Chalcongruppe, insbesondere der Formel IV, enthalten, wie z. B. 1,5-Bis(4-glycidyloxyphenyl)penta-1,4-dien-3-on. Weitere bevorzugte Stoffe sind vinylethergruppenhaltige Derivate von Phenolen, welche eine Chalcongruppe, insbesondere der Formel IV, enthalten, hergestellt durch Umsetzung des Phenols, wie z. B. 1,5-Bis(4-hydroxyphenyl)penta-1,4-dien-3-on, mit einem Haloalkylvinylether, wie z. B. 2-Chlor-ethylvinylether.

Photosolubilisierbare Stoffe, welche bevorzugt als photoempfindliches Material (C) verwendet werden, umfassen Chinondiazide, insbesondere Benzochinon- und Naphthochinondiazidsulfonsäureester von Phenolen, insbesondere von phenolischen Novolakharzen, wie z. B. die in den britischen Patentschriften 1 227 602, 1 329 888 und 1 330 932 und in der US Patentschrift 4 306 010 beschriebenen. Diese Ester können durch Umsetzung eines phenolischen Novolakharzes mit der Chinondiazidsulfonsäure, oder deren Esterifizierungsderivaten, wie z. B. Sulfonylhalogeniden, hergestellt werden. Üblicherweise werden mindestens 25 %, vorzugsweise mindestens 50 % der phenolischen Hydroxylgruppen nicht esterifiziert. Bevorzugte Ester sind 1,2-Benzochinon-2-diazid-4-sulfonsäure- und 1,2-Naphthochinon-2-diazid-4- und 5-sulfonsäureester von phenolischen Novolakharzen, abgeleitet von Formaldehyd und Phenol, o-, m- oder p-Cresol, o-, m- oder p-tert.-Butylphenol, o-, m- oder p-Octylphenol, oder Gemischen von zwei oder mehreren dieser Phenole. Besonders bevorzugte Ester sind die 1,2-Naphthochinon-2-diazid-5-sulfonsäureester eines Novolakharzes hergestellt aus Formaldehyd und einem Gemisch von m- und p-Cresolen und eines Novolakharzes hergestellt aus einem Gemisch von Phenol und p-tert.-Butylphenol.

Weitere bevorzugte photosolubilisierbare Stoffe, welche als Komponente (C) verwendet werden können, sind o-Nitrophenylacetale, hergestellt aus einem o-Nitrobenzaldehyd und einem zweiwertigen Alkohol,

Polyester solcher Acetale, hergestellt durch Umsetzung der Acetale mit einer Polycarbonsäure, oder einem reaktiven Derivat einer Polycarbonsäure, wie z. B. einem Anhydrid, und verkappte Derivate solcher Acetale, hergestellt durch Umsetzung der Acetale mit einer Carbonsäure oder einem reaktiven Derivat einer Carbonsäure. Bevorzugt sind Acetale, welche vom o-Nitrobenzaldehyd und einem linearen Alkylenglykol, in dem die Alkylengruppe 4 bis 15 Kohlenstoffatome hat, die durch mindestens ein Sauerstoffatom unterbrochen werden können, oder einem Glykol, der einen 4 bis 7 kohlenstoffatomhaltigen cycloaliphatischen Ring enthält, wie z. B. Cycloalkylenglykol oder Cycloalkylenalkylenglykol abgeleitet sind, sowie Polyester und verkappte Derivate solcher Acetale.

Bevorzugte lineare Glykole, von denen die Acetale abgeleitet werden können, sind 1,4-Butandiol, 1,5-Pentandiol, 1,6-Hexandiol, 1,7-Heptandiol, Diethylen-, Dipropylen-, Triethylen- und Tripropylenglykol. Bevorzugte Glykole mit einem cycloaliphatischen Ring sind 2,2,4,4-Tetramethyl-1,3-cyclobutandiol, Bis(4-hydroxycyclohexyl)methan, 1,4-Cyclohexandiol, 1,2-Bis(hydroxymethyl)cyclohexan und insbesondere 1,4-Bis(hydroxymethyl) cyclohexan.

Bevorzugte Polyesteracetale sind solche, die durch Umsetzung der oben beschriebenen bevorzugten Acetale mit einer aromatischen Dicarbon- oder Tricarbonsäure oder deren Anhydriden, wie z. B. Phthalsäure, Terephthalsäure und Trimellitsäure und deren Anhydride, und Gemische von zwei oder mehreren dieser Säuren oder Anhydride, erhalten werden. Ein besonders bevorzugter Polyesteracetal wird durch Umsetzung eines vom o-Nitrobenzaldehyd und 1,4-Bis-(hydroxymethyl)-cyclohexan abgeleiteten Acetals mit Trimellitsäureanhydrid erhalten. Bevorzugte verkappte Polyacetale werden durch Umsetzung der bevorzugten oben beschriebenen Acetale mit einer Monocarbonsäure oder einem rektiven Derivat einer Monocarbonsäure erhalten, wie z. B. mit Essig- und Benzoesäure und deren Chloriden.

Weitere bevorzugte photosolubilisierbare Stoffe, die als Komponente (C) verwendet werden kännen, sind Harze, insbesondere Epoxidharze, Polyurethane und Polyester, die in der Kette Benzoingruppen enthalten, wie z. B. die in der US Patentschrift 4 368 253 beschriebenen Stoffe. Unter den benzoingruppenhaltigen Harzen werden solche bevorzugt, in denen die Hydroxylgruppe am Nachbarkohlenstoffatom zur Carbonylgruppe verethert ist, d.h. solche mit Benzoinalkylethergruppen, worin die Alkylgruppen 1 bis 4 Kohlenstoffatome aufweisen. Besonders bevorzugt sind Epoxidharze, hergestellt durch Umsetzung eines Dihydroxybenzoinalkylethers mit einer Diglycidylverbindung, insbesondere mit einem Diglycidylether eines zweiwertigen Alkohols oder Phenols oder einem Diglycidylhydantoin. Benzoingruppenhaltige Epoxidharze können im erfindungsgemässen Verfahren als doppelfunktionelle Stoffe verwendet werden, wobei die Epoxidgruppen die kationische Polymerisierung in Stufe (ii) und die Benzoingruppen die Photosolubilisierung in Stufe (iv) bewerkstelligen.

Das flüssige Stoffgemisch kann auch ein hydrophiles Polymer enthalten, um die Herstellung eines wasserentwickelbaren Bildes zu erleichtern. Geeignete hydrophile Polymeren umfassen Polyalkylenglykole, wie z. B. Polyethylenglykol, Polyacrylamide, Polyvinylpyrrolidone und insbesondere Polyvinylalkohole (hydrolysierte Polyvinylacetate). Falls ein hydrophiles Polymer verwendet wird, setzt man es im allgemeinen in einer Menge von 0,5 bis 20 Gew.-% bezogen auf das Stoffgemisch ein.

Es versteht sich von selbst, dass das Substrat, auf welchem nach dem erfindungsgemässen Verfahren das Bild erzeugt wird, eine elektrisch leitfähige Oberfläche aufweisen muss. Es kann aus Kohlenstoff, Silicium, einem leitfähigen Kunststoff, wie z. B. einem leitfähige Teilchen enthaltenden Duroplast, oder vorzugsweise aus einem Metall, wie z. B. Aluminium, Kupfer oder Weissblech, entweder in Form einer festen Metallplatte oder in Form eines metallbeschichteten Laminats sein.

Stufe (ii) des erfindungsgemässen Verfahrens wird geeigneterweise durch Mischen des polymerisierbaren Materials (A), des Polymerisierungsreagens (B) und des photoempfindlichen Materials (C) in einem wässrigen, organischen oder wässrig-organischen Lösungsmittel in einem Elektrolytbad, Einsetzen des Substrats als Anode und eines ähnlichen oder verschiedenen leitfähigen Materials als Kathode, und Durchleiten eines Stroms bis eine geeignet dicke Schicht des polymerisierten Materials auf der Anode abgeschieden ist, durchgeführt. Die Anode wird dann aus dem Bad entfernt und üblicherweise bei erhöhter Temperatur, insbesondere zwischen 70-110°C, getrocknet. Durch Umpolung des Stroms oder durch Verwendung eines Wechselstroms kann das polymerisierte Material auf beiden Elektroden abgeschieden werden.

Das Gesamtgewicht der Verbindungen der Komponenten (A) und (C) ist im allgemeinen zwischen 5 bis 80 %, vorzugsweise 10 bis 50 % des Gesamtgewichtes des flüssigen Stoffgemisches (samt Lösungsmittel). Wenn das Stoffgemisch verschiedene Verbindungen (A) und (C) enthält, ist die Menge von (A) im Gemisch von (A) und (C) üblicherweise zwischen 10 bis 90 %, insbesondere zwischen 25 und 75 %. Wenn das Stoffgemisch ein Gemisch von doppelfunktionellen Verbindungen mit einer oder mehreren kationisch polymerisierbaren Verbindungen (A) und/oder einer oder mehreren verschiedenen photoempfindlichen Verbindungen (C) enthält, kann die Menge des doppelfunktionellen Materials im Gemisch zwischen 10 und 90 Gew.-% sein. Die verwendete Menge des Polymerisierungsreagens (B) kann relativ stark variieren, ist aber üblicherweise zwischen 0,1 % und 15 % bezogen auf das Gewicht des polymerisierbaren Stoffes (A) und/oder des doppelfunktionellen Stoffes. Das Stoffgemisch wird vorzugsweise bei Raumtemperatur eingesetzt, kann aber je nach Wunsch erhitzt oder gekühlt werden. Temperaturen zwischen 0° bis 80°C haben sich als geeignet erwiesen. Geeignete Lösungsmittel für das vorliegende Verfahren umfassen Ketone, wie z. B. Aceton, Methylethylketon und Methylisobutylketon, halogenierte Kohlenwasserstoffe, wie z. B. Dichlormethan, Chloroform und Tetrachlorethan, Nitroverbindungen, wie z. B. Nitromethan, Nitroethan und Nitrobenzol, Pyrrolidone,wie z. B. N-Methylpyrrolidon, Alkohole, wie z. B. 2-Ethoxyethanol und 2-Butoxyethanol, Gemische

aus zwei oder mehreren dieser Lösungsmittel und, falls sie mit Wasser mischbar sind, Gemische von einem oder mehreren dieser Lösungsmittel mit Wasser. Das Lösungsmittel wird üblicherweise in einer Menge von 10-90 Gew.-%, vorzugsweise 50-90 Gew.-%, des Stoffgemisches verwendet. Die verwendete Stromspannung liegt üblicherweise zwischen 5 V und 150 V, vorzugsweise zwischen 5 V und 100 V, insbesondere zwischen 10 V und 50 V, wobei die Stromstärke, die nötig ist, um eine Abscheidung der Polymerschicht von 1 bis etwa 30 Mikrometern zu verursachen, normalerweise zwischen 10 mA und 10 A liegt.

Die Belichtung mit aktinischer Strahlung erfolgt vorzugsweise in Anwesenheit eines Photosensibilisators, wie z. B. eines Chinons; eines Diphenylcarbinols; 5-Nitroacenaphtens; eines 2-substituierten Thioxanthons; eines Diphenylmethans; eines alpha-Haloacetaophenons, wie z. B. p-tert.-Butylphenyltrichlormethylketon; eines photoredox Katalysators, wie z. B. ein Gemisch eines Phenothiazinfarbstoffs (z. B. Methylenblau), oder eines substituierten Chinoxalins mit einem elektronabgebenden, reduzierenden Reagens, wie z. B. eine Sulfinsäure oder ein Salz einer Sulfinsäure, ein Phosphin, ein Arsin oder Thioharnstoff; eines Benzophenons; eines Benzildialkylketals, wie z. B. Benzildimethylketal (d.h. alpha-Methoxybenzoinmethylether); Benzoin; eines Benzoinalkylethers; und eines 0-Alkoxycarbonylderivats eines Oxims von Benzil oder 1-Phenylpropan-1,2-dion, wie z. B. Benzil(0-ethoxycarbonyl)-alpha-monoxim und 1-Phenylpropan-1,2-dion-2-(0-ethoxycarbonyl)oxim. Bevorzugte Sensibilisatoren sind Michler's Keton (d.h. 4,4'-Bis(di-methylamino)benzophenon), Benzoin-n-buthylether und Gemische dieser zwei Verbindungen; Metallsalze von 2-(m- oder p-Methoxyphenyl)-chinoxalin-6'- oder -7'-sulfonsäuren im Gemisch mit einem Metallsalz von Toluol-p-sulfonsäure; 1-Phenylpropan-1,2-dion-2-(0-ethoxycarbonyl)oxim, Benzildimethylketal und Gemische dieser zwei Verbindungen; sowie 2-Chlorthioxanthon und dessen Gemische mit Benzildimethylketal. Normalerweise werden zwischen 0,1 und 20 Gew.-%, vorzugsweise 0,5 bis 15 Gew.-% des Sensibilisators, bezogen auf das Gewicht des photoempfindlichen Stoffes (C) und/oder des doppelfunktionellen Stoffes, verwendet.

Bei der Bilderzeugung auf der erfindungsgemässen photoempfindlichen Schicht wird vorzugsweise aktinische Strahlung von 200 bis 600 mm verwendet. Geeignete Quellen aktinischer Strahlung umfassen Kohlebögen, Quecksilberdampflampen, fluoreszierende Lampen mit ultraviolettem Licht emittierenden Phosphoren, Argon- und Xenonglühlampen,
Wolframlampen und photographische Flutlichtlampen. Quecksilberdampflampen und insbesondere Sonnenlampen, fluoreszierende Sonnenlampen und Metallhalogenidlampen sind am besten geeignet.

Die erforderliche Belichtungszeit hängt von verschiedenen Faktoren ab, wie der Art der verwendeten Einzelverbindungen, dem Anteil dieser Verbindungen im Stoffgemisch, der Art der Lichtquelle sowie deren Entfernung vom Stoffgemisch. Geeignete Belichtungszeiten können vom Fachmann auf dem Gebiet der Photobilderzeugung auf einfache Art bestimmt werden.

Der im erfindungsgemässen Verfahren verwendete Entwickler kann je nach Art des photoempfindlichen Materials (C) oder des photoempfindlichen Rests des doppelfunktionellen Materials gewählt werden, und kann Wasser, eine wässrige oder wässrig-organische Lösung einer Säure oder Base, oder ein organisches Lösungsmittel oder ein Lösungsmittelgemisch sein. Geeignete Säurelösungen umfassen Lösungen von Essigsäure, Milchsäure, glykolischen oder Toluol-p-sulfonsäuren, während geeignete basische Lösungen Natrium- oder Kaliumhydroxid oder -carbonatlösungen umfassen. Geeignete organische Lösungsmittel sind z. B. Cyclohexanon, 2-Ethoxyethanol, Toluol, Aceton, Tetrahydrofuran, 1,1,1-Trichlorethan, Ethanol sowie Gemische von zwei oder mehreren dieser Lösungsmittel.

Die folgenden Beispiele illustrieren die Erfindung. Alle Teile und Prozente sind Gewichtsteile bzw. -prozente. Spannungen sind Gleichstromspannungen.

Die in den Beispielen verwendeten Harze werden wie folgt hergestellt:

Harz I

2,2-Bis(4-glycidyloxyphenyl)propan mit einem Epoxidgehalt von 5,2 Äquivalenten/kg (100 g) und 2,6-Di-tert.butyl-4-methylphenol (0,1 g) werden gemischt und auf 100°C erhitzt. Diesem Gemisch wird während 1 1/2 Stunden langsam ein Gemisch aus Methacrylsäure (22,8 g), Chrom(III)trisoctanoat (0,05 g) und 2,6-Di-tert.-butyl-4-methylphenol (0,2 g) beigegeben. Das Gemisch wird dann während 4 Stunden bei 100°C erhitzt und anschliessend abgekühlt. Das Produkt, das Harz I, besteht aus einem Gemisch von 2-(4-Glycidyloxyphenyl)-2-[4-(2-hydroxy-3-methacryloyloxypropoxy)phenyl]propan, und weist ein Epoxidgehalt von 1,92 äquivalenten/kg auf.

Harz II

3,4-Epoxycyclohexylmethyl-3',4'-epoxycyclohexancarboxylat mit einem Epoxidgehalt von 7,2 Äquivalenten/kg (100 g) und 2,6-Di-tert.butyl-4-methylphenol (0,1 g) werden vermischt und auf 80°C erhitzt. Diesem Gemisch wird während 30 Minuten langsam ein Gemisch aus Acrylsäure (25,9 g), Chrom(III)trisoctanoat (0,07 g) und 2,6-Di-tert.butyl-4-methylphenol (0,2 g) beigegeben. Das Gemisch wird dann zwei weitere Stunden bei 80°C gerührt, und anschliessend abgekühlt. Das Produkt, das Harz II, besteht aus einem Gemisch von Verbindungen der allgemeinen Formel

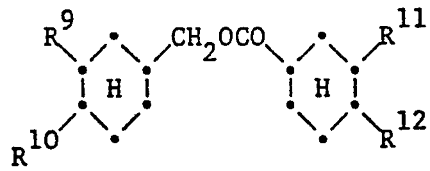

VII,

worin

$R^9$ und $R^{10}$, zusammen mit den Kohlenstoffatomen an welche sie gebunden sind, eine Epoxidgruppe bilden, oder ein Rest eine Hydroxylgruppe und der andere eine Acryloyloxygruppe bedeutet, und

$R^{11}$ und $R^{12}$, zusammen mit den Kohlenstoffatomen an welche sie gebunden sind, eine Epoxidgruppe bilden, oder ein Rest eine Hydroxylgruppe und der andere eine Acryloyloxygruppe darstellt. Das Harz hat einen Epoxidgehalt von 2,4 Äquivalenten/kg.

Harz III

1,5-Bis(4-hydroxyphenyl)penta-1,4-dien-3-on (26,6 Teile) wird in Dimethylsulfoxid (100 Teile) gelöst, und 12 Teile pulverförmiges Natriumhydroxid werden beigegeben. Das Gemisch wird bei Raumtemperatur während 30 Minuten und dann bei 80°C während 1 Stunde gerührt. 2-Chlorethylvinylether (32 Teile) wird während 30 Minuten, bei einer Temperatur zwischen 75° und 80°C dem Gemisch beigegeben, und das Gemisch wird dann bei 80°C 5 Stunden gerührt und über Nacht bei Raumtemperatur stehengelassen. Es wird dann in 500 ml kaltes Wasser gegossen, und der entstandene Niederschlag wird filtriert. Umkristallisierung aus Ethanol ergibt 1,5-Bis(4-vinyloxyethoxyphenyl)penta-1,4-dien-3-on (28,9 Teile), mit einem Schmelzpunkt von 124-125°C.

Harz IV

Das Harz mit einem Molekulargewicht von 1450 wird durch Umsetzung eines Novolaks, der aus 3 Mol Phenol und 1 Mol p-tert.-Butylphenol und 3,6 Mol Formaldehyd hergestellt wird, mit 1,2-Naphthochinon-2-diazid-5-sulfonylchlorid, so dass 12 % der phenolischen Hydroxylgruppen verestert sind, erhalten.

Harz V

o-Nitrobenzaldehyd (100,6 g), 1,4-Bis(hydroxymethyl)cyclohexan (192 g), und Toluol-p-sulfonsäure (0,2 g) werden in einem Kolben mit 600 g Dichlormethan gemischt und unter Stickstoff zur Rückflusstemperatur erhitzt. Das entstehende Wasser wird mit einer Dean und Stark Falle entfernt, und wenn kein Wasser mehr gebildet wird, wird das Lösungsmittel durch Destillation entfernt. Das Gemisch wird dann während 16 Stunden bei 140°C gerührt, und schliesslich werden eventuell noch vorhandene flüchtige Stoffe bei 140°C und einem Druck von 16 mm Hg (2,13 kPa) entfernt. Der Rest wird gekühlt und mit 140 g Xylol verdünnt, so dass eine Lösung mit einem Feststoffgehalt von 66 % erhalten wird.

63,9 g dieser Lösung und 19,2 g Trimellitsäureanhydrid werden unter Rückfluss gerührt, und das gebildete Wasser wird kontinuierlich mit einer Dean und Stark Falle entfernt. Nach 3 Stunden fällt der Säurewert des Reaktionsgemisches auf 1,20 Äquivalenten/kg, und das Xylol wird dann unter Vakuum entfernt. Der Rest wird auf eine Aluminiumschale gegossen und ergibt einen dunkelgrünen Feststoff mit einem Erweichungspunkt von 90°C, welcher zu einem Pulver vermahlen wird. Das Harz V enthält die folgende sich wiederholende Einheit:

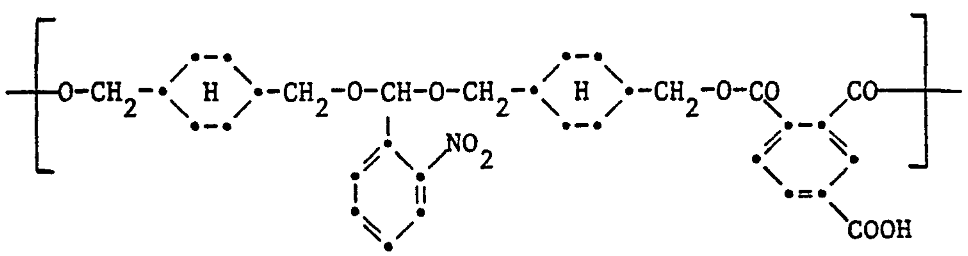

Harz VI

Ein Gemisch aus 4,4'-Dihydroxybenzoin-n-butylether (5,0 g), 1,4-Butandioldiglycidylether (Epoxidgehalt 8,64 Äquivalente/kg, 3,5 g), N,N'-Diglycidyl-5,5-dimethylhadantoin (Epoxidgehalt 7,88 Äquivalenten/kg, 1,4 g) und Tetramethylammoniumchlord (0,02 g) wird in 20,0 g 2-Ethoxyethanol gelöst. Die Lösung wird bei 135°C 2 Stunden lang gerührt, wobei der Epoxidgehalt auf 0,70 Äquivalenten/kg fällt. Die Lösung des vorverlängerten Epoxidharzes wird gekühlt und kann direkt verwendet werden.

Harz VII

N,N'-Diglycidyl-5,5-dimethylhydantoin mit einem Epoxidgehalt von 7,88 Äquivalenten/kg (3,58 g), 4,4'-Dihydroxybenzoin-n-butyl-ether (2,8 g) und N-Benzyldimethylamin (0,02 g) werden in 15 g 2-Ethoxy-ethanol gelöst. Die erhaltene Lösung wird bei 135°C während 2 Stunden erhitzt, wobei der Epoxidgehalt auf 0,90 Äquivalenten/kg fällt. Die Lösung des vorverlängerten Harzes wird gekühlt und kann direkt verwendet werden.

**Beispiel 1:**

Harz I (1 Teil), Benzildimethylketal (0,03 Teile) und Kaliumhexafluorphosphat (0,01 Teil) werden in einem Gemisch aus 1 Teil Dichlormethan und 1 Teil Aceton in einem Elektrolytbad gelöst. Eine Weissblechanode und eine Weissblechkathode werden in das Elektrolytbad eingefügt, und ein elektrischer Strom von 30 V wird während 30 Sekunden durchgeleitet, um eine polymerisierte Schicht auf der Anode abzuscheiden. Die Anode wird aus dem Bad entfernt und 5 Minuten bei 90° C getrocknet. Man erhält eine 16 Mikrometer dicke, klebfreie Schicht. Diese Schicht wird durch ein Negativ mit einer 5000 W Metallhalogenidlampe aus einer Entfernung von 75 cm während einer Minute belichtet. Entwicklung in Toluol ergibt ein klares Negativbild.

**Beispiel 2:**

Harz II (1 Teil), Benzildimethylketal (0,03 Teile) und Kaliumhexafluorphosphat (0,01 Teil) werden in einem Gemisch aus 1 Teil Dichlormethan und 1 Teil Aceton in einem Elektrolytbad gelöst. Ein kupferkaschiertes Laminat wird als Anode und ein Weissblech wird als Kathode eingesetzt. Ein elektrischer Strom von 100 V wird während 2 Sekunden durchgeleitet, um eine polymerisierte Schicht auf der Anode abzuscheiden. Die Anode wird aus dem Bad entfernt und 5 Minuten bei 90° C getrocknet. Man erhält eine klebfreie, 8 Mikrometer dicke Schicht. Diese Schicht wird durch ein Negativ mit einer 5000 W Metallhalogenidlampe aus einer Entfernung von 75 cm während 2 Minuten belichtet. Entwicklung mit einem Gemisch aus gleichen Volumina Aceton und 1,1,1-Trichlorethan ergibt ein klares Negativbild.

**Beispiel 3:**

1 Teil 2,2-Bis(4-glycidyoxyphenyl)propan mit einem Epoxidgehalt von 5,2 Äquivalenten/kg und 0,03 Teile Triphenylsulfoniumhexafluorantimonat werden in einem Gemisch aus 1 Teil Dichlormethan und einem Teil Aceton in einem Elektrolytbad gelöst. Ein kupferkaschiertes Laminat als Anode und eine Weissblechkathode werden eingefügt, und ein Strom von 30 V wird 5 Sekunden lang durchgeleitet, um eine polymerisierte Schicht auf der Anode abzuscheiden. Die Anode wird aus dem Bad entfernt und 5 Minuten bei 90° C getrocknet. Man erhält eine klebfreie 4 Mikrometer dicke Schicht. Diese wird durch ein Negativ während 5 Minuten mit einer 5000 W Metallhalogenidlampe aus einer Entfernung von 75 cm belichtet. Entwicklung mit Tetrahydrofuran ergibt ein klares Negativbild.

**Beispiel 4:**

0,5 Teile 2,2-Bis(4-glycidyloxyphenyl)propan mit einem Epoxidgehalt von 5,2 Äquivalenten/kg, 0,5 Teile 2,2-Bis[4-(2-hydroxy-3-acryloyloxypropoxy)phenyl]propan, 0,02 Teile Kaliumhexafluorphosphat und 0,05 Teile Benzildimethylketal werden in einem Gemisch aus 1 Teil Aceton und 1 Teil Dichlormethan in einem Elektrolytbad gelöst. Eine Anode aus kupferkaschiertem Laminat und eine Weissblechkathode werden eingefügt, und ein Strom von 30 V wird während 20 Sekunden durchgeleitet, um eine polymerisierte Schicht aus der Anode zu erhalten. Die Anode wird aus dem Bad entfernt und 5 Minuten bei 90° C getrocknet. Man erhält eine klebfreie, 7 Mikrometer dicke Schicht. Diese wird durch ein Negativ während 5 Minuten aus einer Entfernung von 75 cm mit einer 5000 W Metallhalogenidlampe belichtet. Nach Entwicklung mit einem Gemisch aus Toluol und Tetrahydrofuran (Volumenverhältnis 8,5 : 1,5) wird ein Negativbild erhalten.

**Beispiel 5:**

0,7 Teile 1,5-Bis(4-glycidyloxyphenyl)penta-1,4-dien-3-on mit einem Epoxidgehalt von 5,26 Äquivalenten/kg, 0,3 Teile 2,2-Bis(4-glycidyloxyphenyl)propan mit einem Epoxidgehalt von 5,2 Äquivalenten/kg und 0,03 Teile Trimethylsulfoxoniumhexafluorantimonat werden in 3 Teilen N-Methylpyrrolidon in einem Elektrolytbad gelöst. Durch die Lösung wird während 60 Sekunden ein Strom von 100 V zwischen einer Anode aus kupferkaschiertem Laminat und einer Kathode aus Weissblech durchgeleitet. Die Anode wird aus dem Bad entfernt und 5 Minuten bei 90° C getrocknet. Man erhält eine klebfreie, 7 Mikrometer dicke Schicht. Diese wird durch ein Negativ während 5 Minuten aus einer Entfernung von 75 cm mit einer 5000 W Metallhalogenidlampe belichtet. Nach Entwicklung mit einem Gemisch aus Ethanol und Tetrahydrofuran (Volumenverhältnis 4 : 1) erhält man ein Negativbild.

**Beispiel 6:**

1 Teil 3,4-Epoxycyclohexylmethyl-3',4'-epoxycyclo-hexancarboxylat, 0,1 Teil ($\eta^6$ -Isopropylbenzol) ($\eta^5$ -cyclopentadienyl)eisen(II)hexafluorantimonat und 0,05 Teile 2-Chlorthioxanthon werden in 2 Teilen Aceton in einem Elektrolytbad gelöst. Durch die Lösung wird zwischen einer Anode aus kupferkaschiertem Laminat und einer Kathode aus Weissblech während 20 Sekunden ein Strom von 30 V durchgeleitet, um auf der Anode eine polymerisierte Schicht abzuscheiden. Die Anode wird aus dem Bad entfernt und 5 Minuten bei 90°C getrocknet. Man erhält eine klebfreie, 10 Mikrometer dicke Schicht. Diese wird durch ein Negativ während 5 Minuten aus einer Entfernung von 75 cm mit einer 5000 W Metallhalogenidlampe belichtet. Nach Entwicklung mit Tetrahydrofuran erhält man ein Negativbild.

**Beispiel 7:**

0,25 Teile Harz III, 0,5 Teile 3,4-Dihydro-2H-pyran-2-yl-methyl-3,4-dihydro-2H-pyran-2-carboxylat und 0,03 Teile Kaliumhexafluorphosphat werden in einem Gemisch aus 3 Teilen N-Methylpyrrolidon und 0,25 Teilen Aceton in einem Elektrolytbad gelöst. Durch die Lösung wird zwischen einer Anode aus kupferkaschiertem Laminat und einer Weissblechkathode während 30 Sekunden ein Strom von 100 V durchgeleitet, um eine polymerisierte Schicht auf der Anode abzuscheiden. Die Anode wird aus dem Bad entfernt und 10 Minuten bei 90°C getrocknet. Man erhält eine klebfreie, 5 Mikrometer dicke Schicht. Diese wird während 5 Minuten durch ein Negativ aus einer Entfernung von 75 cm mit einer 5000 W Metallhalogenidlampe belichtet. Nach Entwicklung mit Toluol durch leichtes Reiben wird ein Negativbild erhalten.

**Beispiel 8:**

0,7 Teile des Harzes IV, 0,3 Teile Iso-octylglycidylether und 0,03 Teile Kaliumhexafluorphosphat werden in einem Gemisch aus 2,2 Teilen 2-Butoxyethanol und 1 Teil Wasser in einem Elektrolytbad gelöst. Durch die Lösung wird zwischen der Anode aus kupferkaschiertem Laminat und einer Weissblechkathode während 5 Sekunden ein Strom von 30 V durchgeleitet, um eine polymerisierte Schicht auf der Anode abzuscheiden. Die Anode wird aus dem Bad entfernt und 5 Minuten bei 90°C getrocknet. Man erhält eine klebfreie, 6 Mikrometer dicke Schicht. Diese wird durch ein Negativ während 2 Minuten aus einer Entfernung von 75 cm mit einer 5000 W Metallhalogenidlampe belichtet. Nach Entwicklung mit einer 2 %-igen Natriumhydroxidlösung durch leichtes Reiben wird ein Positivbild erhalten.

**Beispiel 9:**

0,7 Teile des Harzes IV, 0,3 Teile 3,4-Epoxycylohexyl-methyl-3',4'-epoxycyclohexancarboxylat und 0,03 Teile Bortrifluorid-Ethylaminkomplex werden in 2 Teilen 2-Butoxyethanol in einem Elektrolytbad gelöst. Durch die Lösung wird zwischen einer Anode aus kupferkaschiertem Laminat und einer Weissblechkathode während 30 Sekunden ein Strom von 100 V durchgeleitet, um eine polymerisierte Schicht auf der Anode zu erhalten. Die Anode wird aus dem Bad entfernt und 5 Minuten bei 90°C getrocknet. Man erhält eine klebfreie, 12 Mikrometer dicke Schicht. Diese wird während 2 Minuten aus einer Entfernung von 75 cm mit einer 5000 W Metallhalogenidlampe durch ein Negativ belichtet. Nach Entwicklung mit einer 2 %-igen Natriumhydroxidlösung, durch leichtes Reiben erhält man ein Positivbild.

**Beispiel 10:**

0,7 Teile des Harzes IV, 0,3 Teile 3,4-Dihydro-2H-pyran-2-yl-methyl-3,4-dihydro-2H-pyran-2-carboxylat und 0,03 Teile Tetramethylammoniumhexafluorantimonat werden in einem Gemisch aus 2 Teilen 2-Butoxyethanol und 1 Teil Aceton in einem Elektrolytbad gelöst. Durch die Lösung wird zwischen der Anode aus kupferkaschiertem Laminat und einer Weissblechkathode während 5 Sekunden ein Strom von 30 V durchgeleitet, um eine polymerisierte Schicht zu erhalten. Die Anode wird aus dem Bad entfernt und 5 Minuten bei 90°C getrocknet. Man erhält eine klebfreie, 6 Mikrometer dicke Schicht. Diese wird während 2 Minuten aus einer Entfernung von 75 cm mit einer 5000 W Metallhalogenidlampe durch ein Negativ belichtet. Nach Entwicklung mit einer 2 %-igen Natriumhydroxidlösung durch leichtes Reiben, erhält man ein Positivbild.

**Beispiel 11:**

0,7 Teile des Harzes IV, 0,3 Teile 2,2-Bis(4-glycidyloxyphenyl)propan mit einem Epoxidgehalt von 5,2 Äquivalenten/kg und 0,03 Teile Kaliumhexafluorphosphat werden in einem Gemisch aus 2 Teilen 2-Butoxyethanol und einem Teil Wasser in einem Elektrolytbad gelöst. Durch die Lösung wird zwischen einer Anode aus kupferkaschiertem Laminat und einer Weissblechkathode während 5 Sekunden ein Strom von 30 V durchgeleitet, um eine polymerisierte Schicht auf der Anode abzuscheiden. Die Anode wird aus dem Bad entfernt und 5 Minuten bei 90°C getrocknet. Man erhält eine klebfreie, 8 Mikrometer dicke Schicht. Diese wird durch ein Negativ während 2 Minuten aus einer Entfernung von 75 cm mit einer 5000 W Metallhalogenidlampe belichtet. Nach Entwicklung mit 2 %-iger Natriumhydroxidlösung durch leichtes Reiben wird ein Positivbild erhalten.

**Beispiel 12:**

0,7 Teile des Harzes IV, 0,3 Teile 1,4-Bis(glycidyloxy)-butan und 0,03 Teile Kaliumhexafluorphosphat werden in einem Gemisch aus 2 Teilen 2-Butoxyethanol und 1 Teil Wasser in einem Elektrolytbad gelöst. Durch die Lösung wird zwischen einer Anode aus kupferkaschiertem Laminat und einer Weissblechkathode während 5 Sekunden ein Strom von 20 V durchgeleitet, um eine polymerisierte Schicht auf der Anode abzuscheiden. Die Anode wird aus dem Bad entfernt und 5 Minuten bei 90°C getrocknet. Man erhält eine klebfreie, 8 Mikrometer dicke Schicht. Diese wird durch ein Negativ während 2 Minuten aus einer Entfernung von 75 cm mit einer 5000 W Metallhalogenidlampe belichtet. Nach Entwicklung mit einer 2 %-igen Natriumhydroxidlösung durch leichtes Reiben wird ein Positivbild erhalten.

**Beispiel 13:**

0,3 Teile des Harzes V, 0,7 Teile 2,2-Bis(4-glycidyloxyphenyl)propan mit einem Epoxidgehalt von 5,2 Äquivalenten/kg und 0,03 Teile Kaliumhexafluorphosphat werden in einem Gemisch aus 2,5 Teilen 2-Butoxyethanol und 1 Teil Wasser und 0,28 Teilen einer 20 %-igen wässrigen Kaliumhydroxidlösung in einem Elektrolytbad gelöst. Durch die Lösung wird zwischen einer Anode aus kupferkaschiertem Laminat und einer Kathode aus Weissblech während 5 Sekunden ein Strom von 100 V durchgeleitet, um eine polymerisierte Schicht auf der Anode abzuscheiden. Die Anode wird aus dem Bad entfernt und 5 Minuten bei 90°C getrocknet. Man erhält eine klebfreie, 12 Mikrometer dicke Schicht. Diese wird durch ein Negativ während 5 Minuten aus einer Entfernung von 75 cm mit einer 5000 W Metallhalogenidlampe belichtet. Nach Entwicklung mit einer 2 %-igen Natriumhydroxidlösung durch leichtes Reiben wird ein Positivbild erhalten.

**Beispiel 14:**

1 Teil des Harzes VI, 1 Teil des Harzes VII und 0,3 Teile Kaliumhexafluorphosphat werden in 5 Teilen Aceton in einem Elektrolytbad gelöst. Durch die Lösung wird zwischen einer Weissblechanode und einer Weissblechkathode während 2 Sekunden ein Strom von 10 V durchgeleitet, um eine polymerisierte Schicht auf der Anode zu erhalten. Die Anode wird aus dem Bad entfernt und 5 Minuten bei 90°C getrocknet. Man erhält eine klebfreie, 5 Mikrometer dicke Schicht. Diese wird durch ein Negativ während 5 Minuten aus einer Entfernung von 75 cm mit einer 5000 W Metallhalogenidlampe belichtet. Nach Entwicklung mit einer 2 %-igen Natriumhydroxidlösung durch leichtes Reiben, wird ein Positivbild erhalten.

**Beispiel 15:**

1 Teil 3,4-Epoxycyclohexylmethyl-3',4'-epoxycyclohexan-carboxylat, 1 Teil einer 13 %-igen wässrigen Lösung von Polyvinylalkohol (87-89 % hydrolysiertes Polyvinylacetat) mit einem Molekulargewicht von 125 000, 0,06 Teile Triphenylsulfoniumhexafluorantimonat (50 %-ige Lösung in Propylencarbonat) und 0,1 Teil eines ethoxylierten Nonylphenol-oberflächenaktiven Stoffes (30 Mol Ethylenoxid pro Mol Nonylphenol) werden in einem Gemisch aus 2 Teilen Wasser und 0,5 Teilen 2-Butoxyethanol in einem Elektrolytbad gelöst. Durch die Lösung wird zwischen der Anode aus kupferkaschiertem Laminat und einer Weissblechkathode während 5 Sekunden ein Strom von 30 V durchgeleitet, um eine polymerisierte Schicht auf der Anode abzuscheiden. Die Anode wird aus dem Bad entfernt und 5 Minuten bei 90°C getrocknet. Man erhält eine klebfreie, 10 Mikrometer dicke Schicht. Diese wird durch ein Negativ während 5 Minuten aus einer Entfernung von 75 cm mit einer 5000 W Metallhalogenidlampe belichtet. Nach Entwicklung mit warmen Wasser (40°C), durch leichtes Reiben wird

ein Negativbild erhalten.

**Beispiel 16:**

1 Teil 1,5-Bis(4-glycidyloxyphenyl)penta-1,4-dien-3-on und 0,01 Teil Kaliumhexafluorphosphat werden in 3 Teilen N-Methylpyrrolidon in einem Elektrolytbad gelöst. Durch die Lösung wird zwischen der Anode aus kupferkaschiertem Laminat und einer Weissblechkathode während 30 Sekunden ein Strom von 30 V durchgeleitet, um eine polymerisierte Schicht auf der Anode abzuscheiden. Die Anode wird aus dem Bad entfernt und 5 Minuten bei 90°C getrocknet. Man erhält eine klebfreie, 8 Mikrometer dicke Schicht. Diese wird durch ein Negativ während 5 Minuten aus einer Entfernung von 75 cm mit einer 5000 W Metallhalogenidlampe belichtet. Nach Entwicklung in einem Gemisch aus 1,1,1-Trichlorethan und Toluol (Volumenverhältnis 7:1), durch leichtes Reiben wird ein Negativbild erhalten.

**Patentansprüche**

1. Verfahren zur Bilderzeugung auf Substraten, worin man
(i) das Substrat als Elektrode in ein flüssiges Stoffgemisch eintaucht, welches
(A) ein kationisch polymerisierbares Material,
(B) ein durch elektrischen Strom aktivierbares Polymerisierungsreagens für (A) und
(C) ein photoempfindliches Material enthält,
(ii) durch das flüssige Stoffgemisch zwischen dem Substrat und einer anderen Elektrode elektrischen Strom durchleitet, so dass an der Oberfläche des Substrats eine photoempfindliche Schicht des im wesentlichen festen, polymerisierten Materials abgeschieden wird,
(iii) das Substrat aus dem flüssigen Stoffgemisch entfernt,
(iv) die photoempfindliche Schicht in einem vorbestimmten Muster mit aktinischer Strahlung belichtet, um einen Unterschied in der Löslichkeit zwischen den belichteten und den unbelichteten Teilen der Schicht zu erreichen, und
(v) die löslicheren Teile der Schicht durch Behandlung mit einem Lösungsmittel entfernt, und die weniger löslichen Teile der Schicht auf dem Substrat belässt.

2. Verfahren nach Anspruch 1, worin das flüssige Stoffgemisch entweder 1) ein Gemisch einer oder mehrerer Verbindungen (A), welche ausschliesslich kationisch polymerisierbar sind, mit einer oder mehreren Verbindungen (C), welche ausschliesslich photoempfindlich sind, oder 2) eine oder mehrere doppelfunktionelle Verbindungen, welche sowohl kationisch polymerisierbar als auch photoempfindlich sind, als beides (A) und (C), gegebenenfalls zusammen mit einer oder mehreren ausschliesslich photoempfindlichen Verbindungen und/oder einer oder mehreren ausschliesslich kationisch polymerisierbaren Verbindungen, enthält.

3. Verfahren nach den Ansprüchen 1 oder 2, worin (A) ein 1,2-Epoxid, ein Phenoplast, ein Aminoplast oder ein cyclischer Vinylether ist.

4. Verfahren nach einem der vorhergehenden Ansprüche, worin (B) ein Salz der Formel

$$\left[A^{y+}\right]_a \quad \left[Z^{x-}\right]_b \qquad I,$$

ist, worin
$A^{y+}$ ein Kation, welches ein Metall, ein Metallkomplex, ein organometallisches oder ein heterocyclisches Ion der ein Ammonium-, ein Sulfonium-, ein Iodonium-, ein Sulfoxonium-, ein Iodosyl-, ein substituiertes Ammonium- oder ein Phosphoniumion ist,
$Z^{x-}$ ein Anion einer protischen Säure ist, und
a, b, x und y jeweils 1, 2 oder 3 bedeuten, wobei (ay) gleich (bx) ist.

5. Verfahren nach Anspruch 4, worin das Anion $Z^{x-}$ von einer organischen Carbonsäure, einer organischen Sulfonsäure $Y\text{-}SO_3H$, worin Y eine aliphatische, aromatische oder eine aliphatisch-substituierte aromatische Gruppe darstellt, die alle durch einen oder mehrere Halogenatome substituiert sein können, oder ein Pentafluorhydroxoantimonat oder ein Anion der Formel
$MQ_d^-$
ist, worin
M für ein Metall- oder Metalloidatom, ausgewählt aus Bor, Phosphor, Antimon und Arsen steht,
Q ein Halogenatom darstellt, und
d eine ganze Zahl von 4 bis 6, die um eins höher als die Wertigkeit von M ist, bedeutet.

6. Verfahren nach einem der Ansprüche 1 bis 3, worin (B) ein Bortrifluoridkomplex mit einem Amin oder mit

einem mit drei aliphatischen oder aromatischen Gruppen substituierten Phosphin ist.

7. Verfahren nach einem der vorhergehenden Ansprüche, worin (C) ein photohärtbares Material ist, in welchem die Härtung durch direkte Strahlungsaktivierung einer photoempfindlichen Gruppe eingeleitet wird.

8. Verfahren nach einem der Ansprüche 1 bis 6, worin (C) ein photohärtbares Material ist, in welchem die Strahlung ein geeignetes Initiatormolekül aktiviert, und dieses dann photopolymerisierbare Gruppen aktiviert.

9. Verfahren nach einem der Ansprüche 2 bis 8, worin das flüssige Stoffgemisch als doppelfunktionelles Material ein epoxidgruppen- oder methylolgruppenhaltiges Acrylat, Methacrylat, Chalcon oder Cinnamat, oder ein vinylgruppenhaltiges Chalcon enthält.

10. Verfahren nach einem der Ansprüche 1 bis 6, worin (C) ein photosolubilisierbares Material ist.

11. Verfahren nach Anspruch 10, worin (C) ein Chinondiazid, ein o-Nitrophenylacetal oder ein Polyester oder ein verkapptes Derivat davon, oder ein eine Benzoingruppe in der Kette enthaltendes Harz ist.

12. Verfahren nach einem der vorhergehenden Ansprüche, worin das flüssige Stoffgemisch zusätzlich ein hydrophiles Polymer enthält.

13. Verfahren nach einem der vorhergehenden Ansprüche, worin man die Stufe (ii) durch Mischen von (A), (B) und (C) in einem wässrigen, organischen oder wässrig-organischen Lösungsmittel in einem Elektrolytbad, Eintauchen des Substrats als Anode und eines ähnlichen oder verschiedenen leitfähigen Materials als Kathode und Durchleiten des Stroms bis sich eine geeignet dicke Schicht des polymerisierten Materials an der Anode abgelagert hat, durchführt.

14. Verfahren nach einem der vorhergehenden Ansprüche, worin in der Stufe (ii) ein Strom von 5 V bis 100 V verwendet wird.

**Claims**

1. A process for the production of an image on substrates which comprises.

(i) inserting the substrate as an electrode into a liquid composition containing

(A) a cationically polymerizable material, (B) a polymerizing reagent for (A) which can be activated by an electric current, and

(C) a photosensitive material,

(ii) passing an electric current through the liquid composition between the substrate and another electrode, such that a photosensitive layer of essentially solid, polymerized material is deposited on the surface of the substrate,

(iii) removing the substrate from the liquid composition,

(iv) exposing the photosensitive layer to actinic radiation in a predetermined pattern so as to effect a difference in solubility between exposed parts and unexposed parts of the layer, and

(v) removing more soluble parts of the layer by treatment with a solvent, leaving less soluble parts of the layer on the substrate.

2. A process according to claim 1, in which the liquid composition contains either

(1) a mixture of one or more compounds (A) which are exclusively cationically polymerizable with one or more compounds (C) which are exclusively photosensitive, or (2) one or more dual functional compounds which are both cationically polymerizable and photosensitive, as both (A) and (C), if appropriate together with one or more exclusively photosensitive compounds and/or one or more exclusively cationically polymerizable compounds.

3. A process according to claim 1 or 2, in which (A) is a 1,2-epoxide, a phenoplast, an aminoplast or a cyclic vinyl ether.

4. A process according to any one of the preceding claims, in which (B) is a salt of the formula

$$\left[A^{y+}\right]_a \left[Z^{x-}\right]_b \qquad I,$$

where

$A^{y+}$ is a cation which is a metal, a metal complex, an organometallic or a heterocyclic ion, the (sic) an ammonium, a sulfonium, an iodonium, a sulfoxonium, an iodosyl, a substituted ammonium, or a phosphonium ion,

$Z^{x-}$ is an anion of a protic acid, and

a, b, x, and y each denote 1, 2, or 3, (ay) being the same as (bx).

5. A process according to claim 4, in which the anion $Z^{x-}$... (sic) from an organic carboxylic acid, an organic sulfonic acid $Y\text{-}SO_3H$, where Y denotes an aliphatic, aromatic or aliphatic-substituted aromatic group, which can all be substituted by one or more halogen atoms, or is a pentafluorohydroxoantimonate or an anion of the formula

$MQ_d^-$

where

M represents an atom of a metal or metalloid, selected from boron, phosphorus, antimony and arsenic,
Q represents a halogen atom and
d denotes an integer of from 4 to 6 and is one more than the valency of M.

6. A process according to any one of claims 1 to 3, in which (B) is a complex of boron trifluoride with an amine or with a phosphine substituted by three aliphatic or aromatic groups.

7. A process according to any one of the preceding claims, in which (C) is a photocurable material in which cure is initiated by direct activation of a photosensitive group though irradiation.

8. A process according to any one of claims 1 to 6, in which (C) is a photocurable material in which irradiation activates a suitable initiator molecule which then activates photopolymerizable groups.

9. A process according to any of one of claims 2 to 8, in which the liquid compostion contains, as a dual functional material, an epoxy group- or methol group-containing acrylate, methacrylate, chalcone or cinnamate, or a vinlyl group-containing chalcone.

10. A process according to any of one of claims 1 to 6, in which (C) is a photosolubilizable material.

11. A process according to claim 10, in which (C) is a quinone diazide, an o-nitrophenyl acetal or a polyester or capped derivative thereof, or a resin containing a benzoin group in the chain.

12. A process according to any one of the preceding claims, in which the liquid composition also contains a hydrophilic polymer.

13. A process according to any one of the preceding claims, in which step (ii) is effected by mixing (A), (B) and (C), in an aqeuous, organic or aqueous organic solvent in an electrolytic bath, inserting the substrate as anode and a similar or different conductive material as cathode, and passing a current until a suitable thickness of polymerized material has been deposited on the anode.

14. A process according to any one of the preceding claims, in which the current used in step (ii) is at 5 V to 100 V.

**Revendications**

1. Procédé pour créer des images sur des substrats, procédé selon lequel:
(i) on plonge le substrat, comme électrode, dans un mélange liquide qui contient:
(A) une matière polymérisable par voie cationique,
(C) une matière photosensible,
(ii) on fait passer un courant électrique à travers le mélange liquide entre le substrat et une autre électrode de telle façon qu'une couche photosensible de la matière polymérisée, essentiellement solide, soit déposée à la surface du substrat,
(iii) on extrait le substrat du mélange liquide,
(iv) on expose la couche photosensible à un rayonnement actinique conformément à un modèle donné, pour créer une différence de solubilité entre les parties de la couche qui ont été touchées par la lumière et celles qui n'ont pas été touchées, et
(v) on élimine les parties les plus solubles de la couche en traitant celle-ci par un solvant, les parties moins solubles de la couche restant sur le substrat.

2. Procédé selon la revendication 1 dans lequel le mélange liquide contient soit 1) un mélange d'un ou de plusieurs composés (A) qui sont exclusivement polymérisables par voie cationique et d'un ou plusieurs composés (C) qui sont exclusivement photosensibles, soit 2) un ou plusieurs composés à double fonction qui sont à la fois polymérisables cationiquement et photosensibles, jouant à la fois le r•ole de (A) et le r•ole de (C), éventuellement avec un ou plusieurs composés exclusivement photosensibles et/ou un ou plusieurs composés exclusivement polymérisables par voie cationique.

3. Procédé selon l'une des revendications 1 et 2, dans lequel (A) est un époxyde-1,2, un phénoplaste, un aminoplaste ou un éther vinylique cyclique.

4. Procédé selon l'une quelconque des revendications précédentes, dans lequel (B) est un sel répondant à la formule I:

$$\left[A^{y+}\right]_a \quad \left[Z^{x-}\right]_b \qquad \text{I}$$

dans laquelle:
$A^{y+}$ représente un cation, qui est de préférence un métal, un complexe métallique, un composé organométallique, un composé hétérocyclique ou un ion ammonium, sulfonium, iodonium, sulfoxonium, iodosyle, ammonium substitué ou phosphonium,
$Z^{x-}$ représente un anion provenant d'un acide protique et
a, b, x et y représentent chacun un nombre égal à 1, à 2 ou à 3, le produit ay étant égal au produit bx.

5. Procédé selon la revendication 4 dans lequel l'anion est l'anion d'un acide carboxylique organique, d'un acide sulfonique organique $Y\text{-}SO_3H$ dans lequel Y représente un radical aliphatique, un radical aromatique ou

un radical aromatique porteur de substituants aliphatiques, radicaux qui peuvent tous porter un ou plusieurs atomes d'halogéne, ou est un anion pentafluoro-hydroxo-antimoniate ou encore un anion répondant à la formule:

$MQ_d^-$

dans lequel:

M représente un atome de métal ou de métalloide pris dans l'ensemble constitué par le bore, le phosphore, l'antimoine et l'arsenic,

Q représente un atome d'halogène et

d représente un nombre entier de 4 à 6 qui est supérieur d'une unité à la valence de M.

6. Procédé selon l'une quelconque des revendications 1 à 3 dans lequel (B) est un complexe de trifluorure de bore avec une amine ou avec une phosphine porteuse de 3 radicaux aliphatiques ou aromatiques.

7. Procédé selon l'une quelconque des revendications précédentes selon lequel (C) est une matière photodurcissable dans laquelle le durcissement est amorcé par activation directe, au moyen d'un rayonnement, d'un radical photosensible.

8. Procédé selon l'une quelconque des revendications 1 à 6 selon lequel (C) est une matière photodurcissable dans laquelle le rayonnement active une molécule amorceuse appropriée, et celle-ci active ensuite des radicaux photopolymérisables.

9. Procédé selon l'une quelconque des revendications 2 à 8 dans lequel le mélange liquide contient, comme matière à double fonction, un acrylate, un méthacrylate, une chalcone ou un cinnamate, renfermant des radicaux époxy ou des radicaux méthyloliques, ou contient une chalcone renfermant des radicaux vinyles.

10. Procédé selon l'une quelconque des revendications 1 à 6 dans lequel (C) est une matière photosolubilisable.

11. Procédé selon la revendication 10 dans lequel (C) est un quinone-diazide, un o-nitrophénylacétal, un polyester ou un dérivé masqué d'un tel composé, ou est une résine dont la chaîne contient un radical benzoïnique.

12. Procédé selon l'une quelconque des revendications précédentes dans lequel le mélange liquide contient en outre un polymère hydrophile.

13. Procédé selon l'une quelconque des revendications précédentes dans lequel on effectue l'étape (ii) en mélangeant (A), (B) et (C) dans un solvant aqueux, un solvant organique ou un solvant organique-aqueux dans un bain d'électrolyte, en plongeant le substrat comme anode et une matière conductrice identique ou différente, comme cathode, et en faisant passer le courant jusqu'à ce qu'il se soit déposé sur l'anode une couche de la matière polymérisée d'épaisseur convenable.

14. Procédé selon l'une, quelconque des revendications précédentes selon lequel on utilise, dans l'étape (ii), un courant de 5 à 100 V.